# EUROPÄISCHE PATENTSCHRIFT

(11) **EP 0 924 744 B1**
(45) Veröffentlichungstag und Bekanntmachung des Hinweises auf die Patenterteilung: **24.09.2003**
(21) Anmeldenummer: 98115594.8
(22) Anmeldetag: 19.08.1998
(51) Int. Cl.: H01J 37/34, C23C 14/34

(54) **Sputterkathode**
Sputtering cathode
Cathode de pulvérisation

(30) Priorität: 30.10.1997 DE 19747923
(43) Veröffentlichungstag der Anmeldung: 23.06.1999
(73) Patentinhaber: Unaxis Deutschland Holding GmbH, 81476 München (DE)
(72) Erfinder: Adam, Rolf, 63450 Hanau (DE); Bähr, Martin, Dr., 91729 Haundorf-Gräfensteinberg (DE); Krempel-Hesse, Jörg, Dr., 63683 Eckartsborn (DE)

(56) Entgegenhaltungen:
- EP-A- 0 316 523
- EP-A- 0 416 241
- EP-A- 0 504 477
- DE-A- 3 429 988
- DE-A- 4 038 577
- DE-A- 4 201 551
- DE-A- 19 622 605
- DE-A- 19 622 606
- DE-A- 19 622 607
- US-A- 4 865 708
- PATENT ABSTRACTS OF JAPAN vol. 013, no. 431 (C-640), 26. September 1989 & JP 01 165771 A (MATSUSHITA ELECTRIC IND CO LTD), 29. Juni 1989

## Beschreibung

Die Erfindung betrifft eine Sputterkathode mit einem aus mindestens einem Teil gebildeten ebenen, plattenförmigen Target und mit einem hinter dem Target angeordneten wannenförmigen Joch mit Mittelsteg und mit Magneten zur Erzeugung eines in sich geschlossenen Tunnels aus bogenförmig gekrümmten Feldlinien vor der Targetfläche sowie mit drei in die Ebene zwischen dem Target und den dem Target zugekehrten Stirnflächen des Wannenrandes des Jochs eingelegten Blechzuschnitten oder Gruppen von Teilzuschnitten aus magnetisch leitfähigem Material, wobei zwei dieser Blechzuschnitte oder Teilzuschnittgruppen den Bereich oberhalb der Stirnflächen des Wannenrandes und des Mittelstegs und der dritte Blechzuschnitt oder die dritte Gruppe einen Teil des Bereichs zwischen der Stirnfläche des Mittelstegs und der Stirnfläche des Wannenrandes abdecken und alle Blechzuschnitte zusammen zwei sich etwa parallel den Stirnflächen erstreckende Spalte bilden.

Es ist eine Sputterkathode des in Frage stehenden Typs bekannt (US 4,865,708), bei der zwischen dem Target einerseits und dem Magnetjoch andererseits in der Ebene der Magnetreihen, und zwar unterhalb der Ebene der dem Target zugewandten vorderen Magnetflächen Segmente aus permeablem Werkstoff angeordnet sind, um den sich vor dem Target ausbildenden Tunnel aus gekrümmten Feldlinien konkav abzulenken, um so einen breiteren Erosionsgraben am Target und damit eine höhere Targetstandzeit zu ermöglichen.

Weiterhin ist eine Sputterkathode vorgeschlagen worden (DE 196 22 606.6) mit einem Kathodengrundkörper mit einem plattenförmigen Target sowie mit einem hinter dem Target angeordneten Magnetjoch mit zwei in ovaler oder rechteckiger Konfiguration und koaxial zueinander in einer zur Targetebene parallelen Ebene angeordneten, geschlossenen Reihe von Magneten unterschiedlicher Polung, wobei in die Ebene zwischen dem Target und den dem Target zugekehrten Stirnflächen der Magnete Blechzuschnitte oder entsprechend konfigurierte Teilzuschnitte aus magnetisch leitfähigem Material eingelegt sind, wobei zwei der Blechzuschnitt oder Teilzuschnitte eine rahmenförmige Konfiguration aufweisen, wobei jeweils die zwei gerade Längspartien miteinander verbindenden, bogenförmigen Abschnitte der Blechzuschnitte einen vom Kreisbogen abweichenden, beispielsweise einen elliptischen, parabelförmigen oder auch unregelmäßig-bogenförmigen Kantenverlauf aufweisen, so daß jeweils der von zwei benachbarten, bogenförmigen Abschnitten gebildete Spalt einen unregelmäßigen Breitenverlauf aufweist.

Darüber hinaus ist eine Sputterkathode vorgeschlagen worden (DE 196 22 607.4) mit einem hinter dem Target angeordneten Magnetjoch mit zwei in ovaler oder in rechteckiger Konfiguration und koaxial zueinander in einer zur Targetebene parallelen Ebene angeordneten Reihe von Magneten mit drei in die Ebene zwischen dem Target und den dem Target zugekehrten Stirnflächen der Magnete eingelegten Blechzuschnitten oder Gruppen von Teilzuschnitten, wobei zwei dieser Blechzuschnitte oder Teilzuschnittgruppen den Bereich oberhalb der Magnete und der dritte Blechzuschnitt oder die dritte Gruppe einen Teil des Bereichs zwischen den Magnetreihen abdecken und alle Blechzuschnitte zusammen zwei sich etwa parallel der Magnetreihen erstrekkende Spalte bilden.

Der vorliegenden Erfindung liegt die Aufgabe zugrunde, die Magnete und die Segmente so anzuordnen, daß sich zum einen ein flacher und besonders breiter Erosionsgraben während des Sputterbetriebs ausbildet und ein möglichst optimaler Targetabtrag erfolgt, und daß sich zum anderen der Bereich zwischen den beiden sich parallel erstreckenden magnetischen Tunnels möglichst schmal ausbildet.

Diese Aufgabe wird erfindungsgemäß dadurch gelöst, daß die Magnete jeweils in den Jochboden eingefügt sind, wobei die dem Target zu- und abgewandten Seitenflächen der Magnete bündig mit dem Jochboden abschließen.

Weitere Merkmale und Einzelheiten sind in den Patentansprüchen näher beschrieben und gekennzeichnet.

Die Erfindung läßt die verschiedensten Ausführungsmöglichkeiten zu; eine davon ist in den anhängenden Zeichnungen rein schematisch näher dargestellt, und zwar zeigen:
- Fig. 1: die eine Hälfte eine Kathode in perspektivischer Ansicht, wobei das Target und die Blechzuschnitte nur als Fragmente dargestellt sind,
- Fig. 2: den Schnitt quer durch die Kathode nach Fig. 1, bei der eine Reihe von Magneten in den Boden des wannenförmigen Jochs eingelassen ist,
- Fig. 3: den Schnitt quer durch eine Kathode, bei der gegenüber der Ausführungsform nach den Fig. 1 und 2 zusätzlich Magnete auf dem Wannenrand angeordnet sind und
- Fig. 4: den Schnitt quer durch eine Kathode, wie sie in den Fig. 1 und 2 dargestellt ist, jedoch mit zusätzlichen, die Magnete gegen Korrosion schützenden Abdeckblechen.

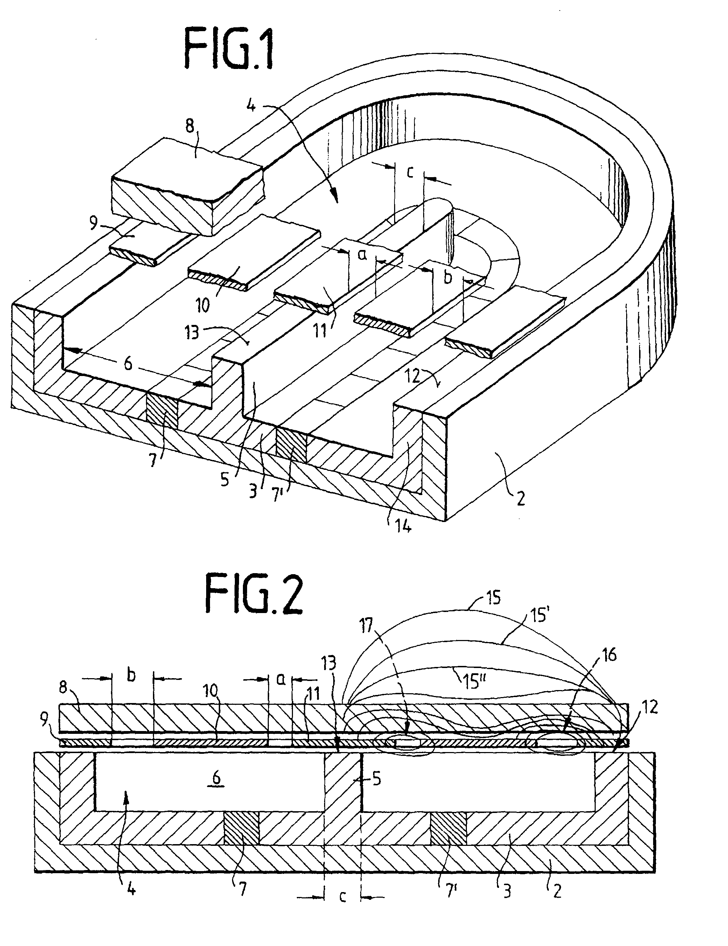

Die Sputterkathode gemäß den Fig. 1 und 2 besteht aus einem wannenförmigen Kathodengrundkörper 2, in den ein ebenfalls wannenförmiges Joch 3 eingelegt ist, wobei das Joch 3 einen die Vertiefung 4 im Joch in Längsrichtung aufteilenden Steg 5 aufweist, dessen Länge so bemessen ist, daß ein ovaler Kühlkanal 6 mit rechteckiger Querschnittsfläche gebildet wird, einer geschlossenen Reihe von würfelförmigen Permanentmagneten 7,7',..., die so in das Bodenteil des Jochs 3 eingelassen sind, daß ihre jeweils dem oberhalb des Jochs 3 angeordneten Target 8 zu- und abgewandten Seitenflächen bündig mit der Bodenfläche der Vertiefung 4 bzw. der Rükkenfläche des Jochs 3 abschließen und drei zwischen dem Target 8 und dem Joch 3 eingelegten Blechzuschnitten 9,10,11, von denen die beiden konzentrisch zueinander vorgesehenen Blechzuschnitte 9 und 10 als ovale Ringe und der mittlere als ein von den ringförmigen Blechzuschnitten 9,10 umschlossener streifenförmiger Blechzuschnitt 11 ausgebildet ist.

Oberhalb des Magnetjochs 3 mit seiner geschlossenen Reihe von Magneten 7 ist das Target 8 angeordnet, das üblicherweise auf seiner der Magnetreihe 7 zugekehrten Unterseite noch fest mit einer Targetgrundplatte versehen ist (nicht näher dargestellt). Die zwischen der Targetunterseite bzw. der Targetgrundplatte einerseits und den oberen Seitenflächen der Magnete 7,7',... andererseits eingelegten Blechzuschnitte 9,10,11 können auch jeweils aus mehreren einzelnen Teilzuschnitten zusammengesetzt sein.

Die drei Blechzuschnitte 9,10,11 schließen zwei Spalte a bzw. b zwischen sich ein, die auf ihrer gesamten Länge gleich groß bemessen oder aber sich verengend oder erweitert ausgebildet sein können. Je nach Spaltbreite a bzw. b werden die Feldlinien 15,15',... mehr oder weniger stark abgelenkt, so daß ein geschlossener Tunnel aus Feldlinien 15,15',... gebildet wird, der abgeflacht ist und damit die Sputterrate insgesamt ausgleicht und ebenso die Targetausnutzung verbessert.

Standard-Magnetronkathoden, bestehend aus einer einfachen Magnetanordnung (zwei Magnetreihen, deren Polarität gegenläugfig ist), erzeugen in ihrem Target im allgemeinen einen spitz zulaufenden Sputtergraben. Dieser ist in der Regel um so schmaler, je tiefer er wird. Ein Vorteil der Erfindung besteht darin, daß ein Magnetfeld geformt wird, das oberhalb der Targetoberfläche und im Target unterschiedlich ist. Das Feld oberhalb der Targetoberfläche entspricht dem der Standard-Magnetronkathoden. Es verläuft annähernd parallel zur Targetoberfläche und tritt an den beiden Seiten des Targets aus bzw. ein. Es entsteht ein sogenanntes Dachfeld.

Im Gegensatz zu herkömmlichen Kathoden ohne zwischen Target und Joch eingelegten Blechen wird bei der erfindungsgemäßen Ausführungsform im Target 8 ein Feld erzeugt, das mindestens aus zwei solchen Dachfeldern 16,17 besteht. Damit teilt sich das Plasma auf der Targetoberfläche in mehrere nebeneinander liegende Teilplasmen auf, wodurch verstärkt nicht mehr der Mittelbereich jeder Targethälfte, sondern deren Randbereiche abgetragen werden, was zu einer erheblichen Erhöhung der Targetausnutzung führt, da der Sputtergraben damit vergleichsweise breiter ausfällt.

Beim Aufbau einer Sputterkathode der in Frage stehenden Art werden größere magnetische Erregungen benötigt als bei herkömmlich aufgebauten Sputterkathoden, da ein größerer Anteil des magnetischen Flusses im Joch und den Blechen und daher nicht über die Targetoberfläche geführt wird. Die gesamte magnetische Flußdichte muß also erhöht werden.

Wenn die erforderlichen Magnete innen und außen (d. h. am Steg und am Wannenrand) positioniert werden, ist der verfügbare Raum für die Magnete durch den Außendurchmesser (Einbaumaß) in der Regel limitiert. Es kann nur - je nach geometrischen Gegebenheiten - ein begrenztes Volumen zum Einbau der notwendigen Magnetmasse verwendet werden. Da die magnetische Feldverteilung bei der Verwendung des infrage stehenden Prinzips wesentlich durch den Feldaustritt an den Spalten a,b definiert wird, ist die tatsächliche Position der Magnete hier jedoch relativ unwichtig. Damit ist es möglich, die Magnete in den Boden des magnetischen Jochs 3 zu integrieren, ohne den relativen Feldverlauf stark zu verändern. Im Boden des Jochs 3 steht vergleichsweise viel Platz für den Einbau von Magneten zur Verfügung. Die Magnete 7,7',... werden deshalb horizontal in den Jochboden eingebaut.

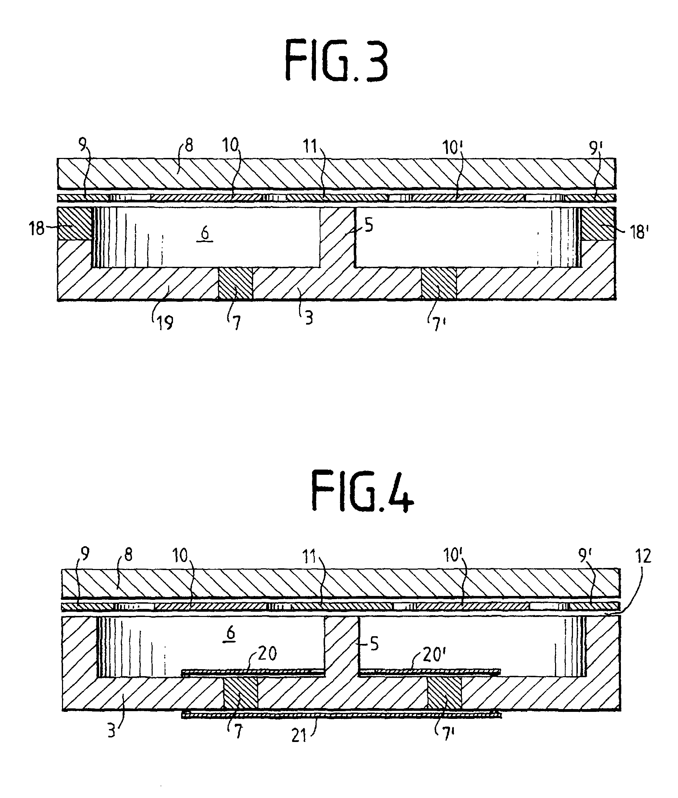

Eine weitere Erhöhung der Magnetmasse kann durch die Kombination von Magneten erzeugt werden, die sowohl horizontal als auch vertikal im Joch integriert sind bzw. auf dieses aufgesetzt werden (siehe Fig. 3). Zusätzlich zu den im Boden eingebauten Horizontalmagneten werden die Magnete 18,18',... auf den umlaufenden Rand der Jochwanne 19 aufgesetzt.

Da insbesondere auf dem Rand 14 des wannenförmigen Jochs 3 und auf dem Mittelsteg 5 bei der Kathode gemäß der vorliegenden Erfindung keine Magnete notwendig sind, können diese Bereiche besonders schmal ausgebildet werden, was zu einer besseren Targetausnutzung führt.

Weiterhin kann bei einer Kathode des beschriebenen Typs leichter eine Wasserkühlung der Magnete realisiert werden, ohne die Magnete selbst mit Wasser in Berührung zu bringen (vergleiche Fig. 4). Um die Magnete 7,7',... vor dem im Kanal 6 strömenden Kühlmittel zu schützen, sind die Magnete 7,7',... mit einem ein geschlossenes Oval bildenden Blechstreifen 20,20' aus einem korrosionsfesten Werkstoff abgedeckt, wobei der Blechstreifen 20,20' mit dem Wannenboden 3 verklebt, verlötet oder verschweißt ist. Auch die Außenflächen der Magnete 7,7',... sind bei der dargestellten Ausführungsform gemäß Fig. 4 durch einen Blechzuschnitt 21 abgedeckt und damit gegen äußere Einflüsse geschützt.

### Bezugszeichenliste

- 2: Kathodengrundkörper
- 3: Joch
- 4: Wanne
- 5: Steg
- 6: Kühlkanal
- 7,7',...: Permanentmagnet
- 8: Target
- 9,9': Blechzuschnitt
- 10,10': Blechzuschnitt
- 11: Blechzuschnitt
- 12: Stirnfläche
- 13: Stirnfläche
- 14: Wannenrand
- 15,15',...: Feldlinie
- 16: magnetisches Dachfeld
- 17: magnetisches Dachfeld
- 18,18',...: Magnet
- 19: Joch
- 20,20': Blechstreifen, Schutzblech
- 21: Blechzuschnitt, Schutzblech

## Patentansprüche

1. Sputterkathode mit einem aus mindestens einem Teil gebildeten ebenen, plattenförmigen Target (8) und mit einem hinter dem Target (8) angeordneten wannenförmigen Joch (3) mit Mittelsteg (5) und mit Magneten (7,7',...) zur Erzeugung eines in sich geschlossenen Tunnels aus bogenförmig gekrümmten Feldlinien (15,15',...) vor der Targetfläche sowie mit drei in die Ebene zwischen dem Target (8) und der dem Target (8) zugekehrten Stirnflächen (12) des Wannenrandes des Jochs (3) eingelegten Blechzuschnitten (9,10,11) oder Gruppen von Teilzuschnitten aus magnetisch leitfähigem Material, wobei zwei dieser Blechzuschnitte (9,11) oder Teilzuschnittgruppen den Bereich oberhalb der Stirnflächen (12,13) des Wannenrandes und des Mittelstegs (5) und der dritte Blechzuschnitt (10) oder die dritte Gruppe einen Teil des Bereichs zwischen der Stirnfläche (13) des Mittelstegs (5) und der Stirnfläche (12) des Wannenrandes abdecken und alle Blechzuschnitte (9,10,11) zusammen zwei sich parallel den Stirnflächen (12,13) erstreckende Spalte (a,b) bilden, **dadurch gekennzeichnet, daß** die Magnete (7,7',...) jeweils in den Jochboden einbezogen oder eingefügt sind, und **daß** die dem Target (8) zu- und abgewandten Seitenflächen der Magnete (7,7',...) bündig mit dem Jochboden abschließen.

2. Sputterkathode nach Anspruch 1, **dadurch gekennzeichnet, daß** die in das Bodenteil des wannenförmigen Jochs (3) eingefügten Magnete (7,7',...) von einer Platte oder Folie (20,20' bzw. 21) abgedeckt sind, wobei die Ränder der Platte oder Folie mit der Bodenfläche des Jochs (3) verklebt, verlötet oder verschraubt sind.

3. Sputterkathode nach Anspruch 1, **dadurch gekennzeichnet, daß** zusätzlich zu den in das Bodenteil des Jochs (3) einbezogenen oder eingefügten Magneten (7,7',...) eine weitere Reihe von Permanentmagneten (18,18',...) auf der dem Target (8) zugekehrten Stirnfläche der umlaufenden Randpartie des wannenförmigen Jochs (3) angeordnet ist, wobei die Höhe der Randpartie mit den auf ihr angeordneten Magneten (18,18',...) der Höhe des Mittelstegs (5) entspricht.

## Claims

1. Sputtering cathode comprising a flat, platelike target (8) formed from at least one part, and comprising a trough-like yoke (3) arranged behind the target (8) and having a central fin (5) and having magnets (7, 7', ...) for producing a self-contained tunnel of field lines (15, 15', ...) curved in an arc shape before the target surface, and comprising three sheet metal blanks (9, 10, 11) or groups of partial blanks of magnetically conductive material which are inserted into the plane between the target (8) and the end faces (12) of the trough edge of the yoke (3) which face the target (8), two of these sheet metal blanks (9, 11) or groups of partial blanks, two of these sheet metal blanks (9, 11) or groups of partial blanks covering the region above the end faces (12, 13) of the trough edge and of the central fin (5) and the third sheet metal blank (10) or the third group covering a part of the region between the end face (13) of the central fin (5) and the end face (12) of the trough edge and all sheet metal blanks (9, 10, 11) together forming two gaps (a, b) extending parallel to the end faces (12, 13), **characterized in that** the magnets (7, 7', ...) are each included in or inserted into the yoke base, and **that** those end faces of the magnets (7, 7', ...) which face or face away from the target (8) are flush with the yoke base.

2. Sputtering cathode according to Claim 1, **characterized in that** the magnets (7, 7', ...) inserted into the base part of the trough-like yoke (3) are covered by a plate or sheet (20, 20' and 21), the edges of the plate or sheet being adhesively bonded, soldered or screwed to the base surface of the yoke (3).

3. Sputtering cathode according to Claim 1, **characterized in that**, in addition to the magnets (7, 7', ...) included in or inserted into the base part of the yoke (3), a further row of permanent magnets (18, 18', ...) is arranged on the end face of the surrounding edge part of the trough-like yoke (3), which end face faces the target (8), the height of the edge part with the magnets (18, 18', ...) arranged on it corresponding to the height of the central fin (5).

## Revendications

1. Cathode de pulvérisation qui comporte une cible (8) plane et discoïdale constituée d'au moins une pièce, et qui comporte - agencée derrière la cible (8) - une culasse (3) en forme de cuvette munie d'une entretoise médiane (5) et d'aimants (7, 7', ...) destinés à la création devant la surface cible d'un tunnel clos formé de lignes de champ en arc (15, 15', ...), et qui comporte, en outre, trois découpes de tôle (9, 10, 11) ou assemblages de découpes partielles dans un matériau magnétiquement conductible encastrés dans le plan entre la cible (8) et les faces frontales (12) du rebord de la cuvette que forme la culasse (3) adjacentes à la cible (8), et dans laquelle deux de ces découpes de tôle (9, 11) ou assemblages de découpes partielles recouvrent la zone au-dessus des faces frontales (12, 13) du rebord de la cuvette et de l'entretoise médiane (5), tandis que la troisième découpe de tôle (10) ou le troisième assemblage recouvre une partie de la zone entre la face frontale (13) de l'entretoise médiane (5) et la face frontale (12) du rebord de la cuvette, moyennant quoi l'ensemble des découpes de tôle (9, 10, 11) constituent deux fentes (a, b) qui s'étendent parallèlement aux faces frontales (12, 13), **caractérisée en ce que** chacun des aimants (7, 7', ...) est intégré ou encastré dans le fond de la culasse et **en ce que** les faces latérales des aimants (7, 7', ...) adjacentes à la cible et celles opposées à la cible se terminent au ras du fond de la culasse.

2. Cathode de pulvérisation selon la revendication 1, **caractérisée en ce que** les aimants (7, 7', ...) encastrés dans le fond de la culasse (3) en forme de cuvette sont recouverts d'une plaque ou d'une feuille métallique (20, 20' voire 21), les bords de cette plaque ou feuille métallique étant collés, brasés ou vissés sur le fond de la culasse (3).

3. Cathode de pulvérisation selon la revendication 1, **caractérisée en ce que**, outre les aimants (7, 7', ...) intégrés ou encastrés dans le fond de la culasse (3), une série supplémentaire d'aimants permanents (18, 18', ...) est agencée sur la face frontale - adjacente à la cible (8) - du rebord périphérique de la culasse (3) en forme de cuvette, la hauteur de ce rebord périphérique - y compris les aimants (18, 18', ...) qui y sont agencés - étant équivalente à la hauteur de l'entretoise médiane (5).
